# EUROPÄISCHE PATENTSCHRIFT

(11) **EP 3 094 917 B1**
(45) Veröffentlichungstag und Bekanntmachung des Hinweises auf die Patenterteilung: **30.06.2021**
(21) Anmeldenummer: 15700208.0
(22) Anmeldetag: 09.01.2015
(51) Int. Cl.: H01L 25/075, H05B 45/20, H01L 33/50

(54) **MEHRKANAL LED-MODUL MIT WEISSEN LEDS UNTERSCHIEDLICHER FARBKOORDINATEN**
MULTICHANNEL LED MODULE WITH WHITE LEDS OF DIFFERENT COLOR COORDINATES
MODULE DE DEL MULTICANAUX COMPORTANT DES DEL BLANCHES DE COORDONNÉES DE COULEURS DIFFÉRENTES

(30) Priorität: 14.01.2014 DE 202014100147 U
(43) Veröffentlichungstag der Anmeldung: 23.11.2016
(73) Patentinhaber: Tridonic GmbH & Co. KG, 6850 Dornbirn (AT)
(72) Erfinder: PACHLER, Peter, A-8042 Graz (AT); LEITGEB, Thomas, A-8350 Fehring (AT)
(74) Vertreter: Rupp, Christian
(86) Internationale Anmeldenummer: PCT/EP2015/050315
(87) Internationale Veröffentlichungsnummer: WO 2015/107003

(56) Entgegenhaltungen:
- US-A1- 2009 050 907
- US-A1- 2009 097 271
- US-A1- 2009 323 334
- US-A1- 2010 002 440
- US-A1- 2010 315 012
- None

## Beschreibung

Die Erfindung bezieht sich auf ein LED-Modul, das wenigstens zwei Kanäle zum Betreiben von LEDs bzw. LED-Strecken mit jeweils wenigstens zwei weissen LEDs aufweist. Dabei ist es Ziel der Erfindung, an den wenigstens zwei LED-Kanälen farbstoffkonvertierte Weisslicht-LEDs zu betreiben. Mittels einer Ansteuerung der LEDs in den wenigstens zwei LED-Kanälen kann insgesamt eine von dem LED-Modul emittierte Farbtemperatur bzw. der Farbort des emittierten Lichts eingestellt werden, insbesondere mittels eines Farbdimmens insbesondere durch eine unterschiedliche Ansteuerung der LEDs in den Kanälen. Dabei sind die in einem Kanal betriebenen LEDs bzw. LED-Chips gruppenweise seriell verschaltet. Das von dem LED-Modul emittierte Licht ist dabei ein durch Weisslicht-LEDs unterschiedlicher Kategorien erzeugtes weisses Mischlicht.

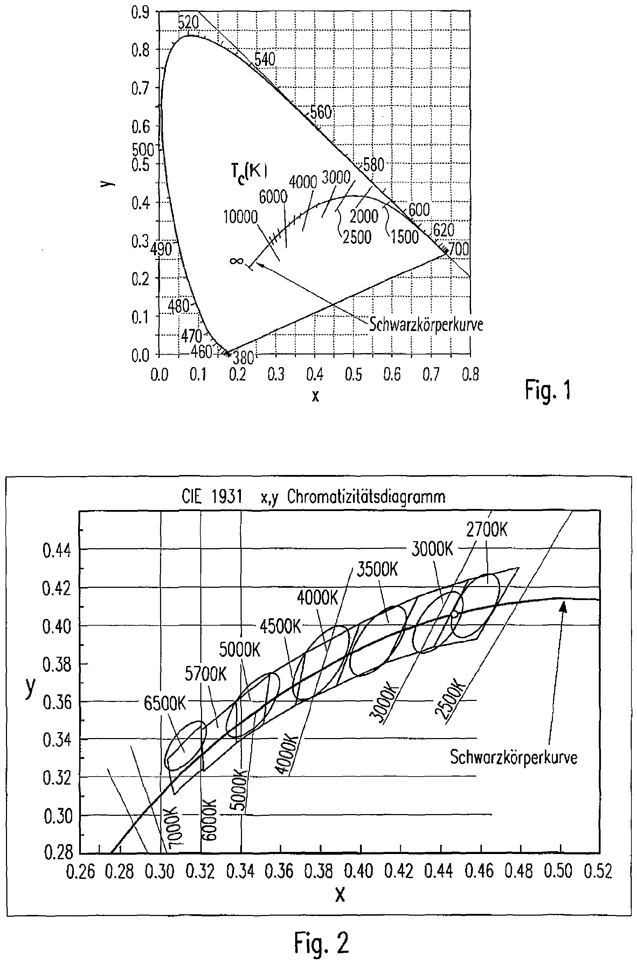

Zur Farbmessung hat die Internationale Beleuchtungskommission (Commission Internationale de l'Eclairage, CIE) das CIE-1931-Chromatizitätsdiagramm entwickelt in dem alle Farben dargestellt sind, die vom menschlichen Auge wahrgenommen werden können. Die Kurve, die die Peripherie bzw. den Rand des Chromatizitätsdiagramms bildet, wird als spektrale Ortskurve bezeichnet. Die spektrale Ortskurve entspricht den Spektralfarben im sichtbaren Lichtspektrum und beinhaltet die entsprechenden Wellenlängenwerte. Das CIE-1931-Diagramm ist ein zweidimensionales Diagramm, in dem die Chromatizität anhand von X- und Y-Koordinaten dargestellt wird. Im CIE-Diagramm werden die Farben so dargestellt, wie sie vom menschlichen Auge in vollem Tageslicht wahrgenommen werden. Die Spektralfarben liegen außen an der hufeisenförmigen Kurve (spektrale Ortskurve). Die untere gerade Linie stellt z.B. die Purpurgerade dar, und bei den Farben im Inneren handelt es sich um ungesättigte Farben, also um eine Mischung einer Spektralfarbe mit einer Farbe der Grauskala. Fig. 1 zeigt ein entsprechendes Diagramm.

Weissem Licht können auch Farbtemperaturen zugeordnet werden. Je nach seinem Farbtemperaturbereich wird weisses Licht als warmes, neutrales oder kaltes weisses Licht bezeichnet. Je höher die Farbtemperatur, umso kälter ist das Licht, und je niedriger die Farbtemperatur, umso wärmer ist das Licht. Kalt bedeutet in diesem Fall insbesondere, dass das weisse Licht bläulicher erscheint, und warm bedeutet insbesondere, dass das weisse Licht rötlicher oder gelblicher erscheint.

So kann rötliches und gelbliches weisses Licht eher dem Licht einer Glühlampe entsprechen, während beispielsweise ein bläuliches weisses Licht eher dem Licht von Gasentladungslampen/Leuchtstofflampen/Neonröhren entspricht.

In Fig. 1 sind verschiedene Farbtemperaturen entlang der sog. Schwarzkörperkurve (Black-Body-Line, BBL) dargestellt.

Das menschliche Auge kann auch sehr geringfügige Farbschwankungen wahrnehmen. Beispielsweise eine Schwankung in der emittierten Wellenlänge bis zu ca. 10 nm bei rot und 2 bis 3 nm bei grün. Bei weissen LEDs kann dies bei manchen Anwendungen ein Problem sein. Bei Anwendungen wie z.B. Taschenlampen oder Scheinwerfern ist eine genaue Abstimmung der Chromatizität des weissen Lichts nicht so wichtig wie bei einer Anwendung mit mehreren LED-Modulen z.B. zur Beleuchtung. Wenn die LEDs nicht präzise abgestimmt sind, kann ein regenbogenartiger Effekt mit unterschiedlichen Schattierungen von weissem Licht beispielsweise an einer beleuchteten Wand entstehen. Bei Glühlampen besteht dieses Problem nicht, weil diese einen breiten Frequenzbereich erzeugen. Zur Minimierung dieser Probleme werden LEDs in so genannten Bins oder Kategorien bereitgestellt.

Unter Binning oder Kategorisierung versteht man den Prozess des systematischen Sortierens und Einteilens von LEDs nach bestimmten Messparametern oder Parametersätzen. So können systematisch bestimmte LEDs spezifiziert werden, die durchgängig die spezifizierten Eigenschaften aufweisen. Außerdem ermöglicht es die Kategorisierung, LEDs gezielt benennen zu können, die die entsprechenden spezifizierten Eigenschaften aufweisen.

Die Kategorisierung (auch Klassierung genannt) erfolgt allgemein anhand von Kategorisierungs-Diagrammen, in denen geometrische Felder auf dem CIE-1931-Diagramm entlang der Schwarzkörperkurve angeordnet sind. Diese Felder werden zur Spezifizierung der Schwankung der Chromatizitätskoordinaten verwendet.

So definiert z.B. das American National Standard Institute (ANSI), wie exemplarisch in Fig. 2 gezeigt ist, Bins/Binning Regionen bzw. Kategorien (schwarz) auf der Basis des CIE-1931-x, y-Farbraums. Die Kategorien entsprechen in etwa MacAdams-7 Ellipsen (grau).

Die Schwarzkörperkurve in Fig. 1 ist die Linie, auf der die Farbtemperaturen für weisses Licht aus Lichtquellen mit einem Farbwiedergabeindex (CRI) von 100 liegen. Die mit 1500K bis 10000K bezeichneten Linien, sind die Kurven, die der jeweiligen nominalen Farbtemperatur (nominale Correlated Color Temperature, CCT) entsprechen.

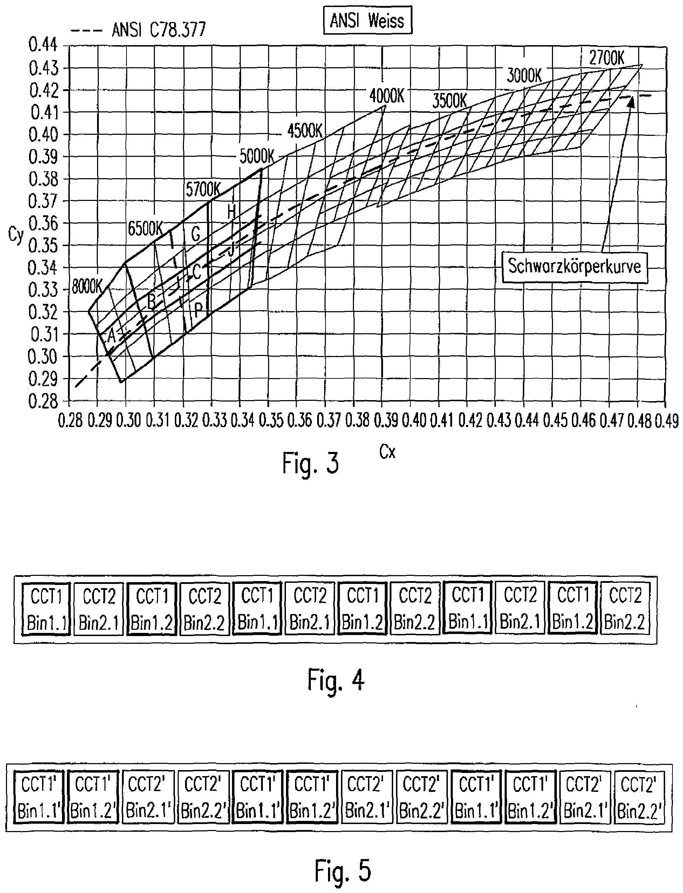

Die in Fig. 2 für die nominalen CCTs gezeigten Kategorien können nun weiter unterteilt werden, bspw. in Unterkategorien wie z.B. bei 2700K in Unterkategorien 8A1-8D4, siehe Fig.3, oder ergänzt werden bzw. kann den Kategorien eine andere Kategorieeinteilung überlagert werden.

Fig. 3 zeigt beispielsweise einen Ausschnitt von Kategorien und Unterkategorien im Bereich um die Schwarzkörperkurve (BBL) im Bereich von ca. 2700K bis ca. 8000K. Diesen Kategorien können nun herstellerspezifische Bezeichnungen zugeordnet werden oder es können herstellerspezifische Kategorien definiert werden. In Fig. 3 sind solche Kategorien mit dicken Umrandungen kenntlich gemacht, die exemplarisch die Bezeichnungen A, B, C, G, H, J und P tragen.

Jedes der Felder, z.B. A, B und C, umfasst zwei Arten an Farbschwankungen. Bei der einen handelt es sich um die Schwankung des Farbtemperatur-Werts (z.B. 5000K bis 5700K in den Feldern H und J). Die andere Schwankung wird als Tönung bezeichnet und gibt die Distanz der Chromatizitätskoordinaten von der Schwarzkörperkurve an. Das obere Ende des Felds G zum Beispiel hat hier eine etwas mehr grünliche Tönung als das untere Ende dieses Felds. Das untere Ende des Felds P hat hier eine etwas mehr rötliche Tönung als das obere Ende dieses Felds. C, zwischen G und P, hat einen kleineren Tönungsbereich. Trotzdem liegen G, C und P alle im gleichen Farbtemperatur-Bereich. Chromatizitätswerte, die direkt auf der Schwarzkörperkurve liegen, haben keine Tönung.

Es ist dabei zu verstehen, dass die Einteilung bzw. Festlegung der Kategorien und/oder Unterkategorien auch anders gewählt sein kann und dass die Kategorien und/oder Unterkategorien anders bezeichnet sein können.

Insgesamt stellt die Kategorisierung also eine herstellerseitige Selektion von LEDs im Bereich der Schwarzkörperkurve für verschiedene Farbtemperaturen dar.

Beispielsweise erfolgt die Kategorisierung anhand eines ANSI-Standards (z.B. C78.377-2008), wobei jeder Weissbereich mit einer bestimmten nominalen CCT nochmals in mehrere Farbtemperaturbereiche (Unterkategorien) untergliedert ist. Die einzelnen nominalen Farbtemperaturbereiche sind im CIE-Farbraum durch x- und y-Koordinaten eindeutig gekennzeichnet. Somit können durch die Klasseneinteilung, bzw. die in einem entsprechenden Diagramm festgelegten Farbflächen, LEDs eindeutig in ihrem Weisston (mit Farbtemperatur und Chromatizitätswerten) gekennzeichnet sein.

Bekannt ist es zudem, dass in heutigen LED-Modulen weisse LEDs unterschiedlicher Farbtemperaturen kombiniert werden. Diese können dann bei unterschiedlichen Intensitätsniveaus betrieben werden, um beispielsweise die Farbtemperatur (CCT) des Moduls ändern zu können. Dies kann insbesondere durch Ansteuerung der LED-Chips mit unterschiedlichen LED-Strömen erfolgen.

Um nun weisslichtemittierende LED-Module mit einer definierten Farbtemperatur bereitstellen und diese Farbtemperatur regulieren zu können, werden LEDs nach diesen Kategorien selektiert, was "Binning" genannt wird. Da das menschliche Auge, wie gesagt, sehr sensibel auf Unterschiede im Weisslicht reagiert, darf die Abweichung in jeder einzelnen Kategorie nur sehr gering sein. Dabei ist zu beachten, dass je weiter eine Kategorie von der Schwarzkörperkurve entfernt liegt, desto stärker sich die emittierte Farbtemperatur ändert, womit typischerweise auch der Preis der entsprechenden LEDs sinkt.

Da es insbesondere nicht möglich bzw. nicht wirtschaftlich ist, lediglich LEDs einzusetzen, die aus nur einer Kategorie stammen, ist es auch notwendig, LEDs zu verwenden, die gemäß der entsprechenden Kategorisierung aus verschiedenen Kategorien stammen. Diese sind dann insbesondere stets so zu kombinieren, dass der jeweils gewünschte Farbort getroffen wird und keine Farbunterschiede entstehen.

Das Dokument US 2010/0315012 A1 zeigt ein Leuchtmittel bestehend aus mehreren weißen LEDs. Dabei werden mehrere weiße LEDs geringfügig abweichender Farben genutzt, um einen bestimmten Weißwert zu erreichen.

Das Dokument US 2009/0050907 A1 zeigt eine LED-Leuchte mit einem Array von LED Chips. Die LED Chips sind dabei in Gruppen aufgeteilt, welche unterschiedliche Lichtfarben emittieren.

Die gegenwärtige Erfindung wird definiert durch den unabhängigen Anspruch. Vorteilhafte Weiterbildungen werden durch die abhängigen Ansprüche definiert. Im folgenden beschriebene Ausführungen, welche nicht von dem unabhängigen Anspruch abgedeckt sind, sind als für das Verständnis hilfreiche Beispiele und nicht als Ausführungsbeispiele der Erfindung zu verstehen.

Die Erfindung schlägt nunmehr ein LED-Modul vor, mit der sowohl die Herstellungskosten gesenkt als auch eine zuverlässige Einstellung des gewünschten Farborts und der Farbtemperatur erfolgen kann. Eine entsprechende Lösung wird gemäß dem Anspruch 1 bereitgestellt. Weitere Ausprägungen der Erfindung sind Gegenstand der abhängigen Ansprüche.

Die Verwendung von LEDs verschiedener Weisslicht-Kategorien wie sie erfindungsgemäß vorgeschlagen wird hat zum einen den Vorteil, dass Kosten gespart werden können, da z.B. LEDs aus verschiedenen Kategorien verwendet werden können, die auch weiter von der Schwarzkörperkurve entfernt liegen und somit günstiger sind. Zum anderen kann dennoch eine definierte Weisslichttemperatur erreicht werden.

In einem Aspekt stellt die Erfindung ein LED-Modul bereit, aufweisend: wenigstens eine erste Gruppe seriell verschalteter farbstoffkonvertierter weisser LEDs und eine zweite Gruppe seriell verschalteter farbstoffkonvertierter weisser LEDs, wobei: die erste Gruppe und die zweite Gruppe an LEDs zueinander parallel geschaltet sind, so dass sie unabhängig voneinander von einer oder mehreren Treiberschaltungen ansteuerbar sind, und sich die nominale Farbtemperatur der LEDs der ersten Gruppe von der nominalen Farbtemperatur der LEDs der zweiten Gruppe unterscheidet, dadurch gekennzeichnet, dass jede Gruppe an LEDs wenigstens zwei Untergruppen mit LEDs aufweist, wobei sich die Untergruppen hinsichtlich les Farborts unterscheiden, und dass: die Gruppen sowie die Untergruppen an LEDs auf einem Träger in einer Erstreckungsrichtung in einem sich periodisch wiederholenden Muster angeordnet sind, die LEDs linear in einer Reihe auf dem Träger angeordnet sind, mindestens zwei LEDs aus der gleichen Gruppe nebeneinander auf dem Träger angeordnet sind, und benachbarte LEDs der linearen Reihenfolge aus unterschiedlichen Untergruppen stammen.

Die nominale Farbtemperatur der ersten Gruppe der farbstoffkonvertierten weissen LEDs kann in einem Bereich zwischen 2000K und 4000K liegen und die nominale Farbtemperatur der zweiten Gruppe der farbstoffkonvertierten weissen LEDs kann in einem Bereich zwischen 5000K und 7500K liegen.

Die LEDs sind linear in einer Reihe auf dem Träger (z.B. SMD, Leiterplatte) angeordnet. Ein Beispiel für SMD (Surface Mount(ed) Devices) sind Chip Scale Packages (CSP), wie sie aus der Halbleiterindustrie bekannt sind. CSP werden typischerweise als Module bereitgestellt, die von ca. gleicher Größe oder etwas größer (z.B. <20%) sind, als der/die LED-Chip/-s (Die/-s) oder der aktive Bereich der LED(s). CSP erfordern meist keinen Unter-Träger (sub-mount) bzw. kein Substrat und können z.B. direkt insbesondere auf Level-2 Trägern befestigt werden. CSP können sowohl P- und N-Kontakte bzw. Kontaktierungsstellen aufweisen, können Bondflächen in einem bekannten bzw. standardisierten Abstand aufweisen und/oder den Einsatz von standardisierten Prüf- und Bestückungsanlagen bzw. -werkzeugen und/oder -verfahren ermöglichen. Das LED-Modul kann daher als SMD bzw. Chip Scale Package bereitgestellt sein oder Teil eines SMD bzw. Chip Scale Packages sein.

Das LED-Modul kann eine oder mehrere Treiberschaltungen aufweisen, die die LED-Gruppen mit einem PWM-modulierten Strom mit einstellbarem Tastverhältnis versorgen. Dabei kann je Gruppe eine Treiberschaltung vorgesehen sein. Die Gruppen können durch die wenigstens eine Treiberschaltung insbesondere verschieden elektrisch versorgt werden, so dass sich zumindest ein unterschiedlicher Betriebsstrom für die LEDs verschiedener Gruppen einstellt.

In einem weiteren Aspekt wird eine Lampe oder Leuchte mit einem LED-Modul, wie es oben beschrieben ist, insbesondere eine Retrofit-LED-Lampe bereitgestellt. Diese kann in ihren Abmessungen den standardisierten Baugrößen für Leuchtstofflampen T2 bis T12 entsprechen.

Die Erfindung wird nunmehr auch mit Bezug auf die Figuren beschrieben. Dabei zeigen:
- Fig. 1: ein Diagramm des CIE-1931-x, y-Farbraums;
- Fig. 2: ein Diagramm mit Kategorien nach ANSI-Standard C78.377-2008;
- Fig. 3: Kategorien nach dem ANSI-Standard mit exemplarischen herstellerspezifischen Kategorien;
- Fig. 4: eine beispielhafte Anordnung von LEDs auf einem LED-Modul das nicht von der beanspruchten Erfindung abgedeckt wird;
- Fig. 5: eine beispielhafte alternative Anordnung von LEDs auf einem LED-Modul das von der beanspruchten Erfindung abgedeckt wird;
- Fig. 6: Kategorien für LEDs für eine erste Farbtemperatur; und
- Fig. 7: Kategorien für LEDs für eine zweite Farbtemperatur.

Fig. 4 zeigt eine beispielhafte Anordnung von LEDs auf einem LED-Modul das nicht von der beanspruchten Erfindung abgedeckt wird, bei dem LEDs aus zwei Kategorien jeweils eine nominale Farbtemperatur (nominal correlated color temperature, nominale CCT) erzeugen. Dabei werden die einer ersten nominalen Farbtemperatur zugeordneten LEDs in zwei Unterkategorien in einem ersten LED-Kanal betrieben, während die LEDs aus den beiden Unterkategorien für die zweite nominale Farbtemperatur in einem zweiten LED-Kanal betrieben werden. Letztlich wird von dem LED-Modul dann ein Weisslicht mit einer aus den beiden nominalen Farbtemperaturen erzeugten/gemischten Farbtemperatur emittiert.

Die in Fig. 4 dargestellte abwechselnde Anordnung von LEDs einer Unterkategorie der ersten nominalen Farbtemperatur und einer Unterkategorie der zweiten nominalen Farbtemperatur hat jedoch den Nachteil, dass durch die Verwendung von LEDs aus unterschiedlichen Unterkategorien und mögliche Unterschiede in den versorgenden LED-Strömen Farbunterschiede in dem von dem LED-Modul abgegebenen Licht, insbesondere lokal, sichtbar werden.

In Fig. 4 ist insbesondere eine LED einer ersten Gruppe (CCT1) abwechselnd mit einer LED einer zweiten Gruppe (CCT2) abwechselnd angeordnet. Die beiden Gruppen weisen dabei Untergruppen auf, also insbesondere LEDs aus verschiedenen Unterkategorien. So weist die erste Gruppe CCT1 die Untergruppen Bin 1.1 und Bin 1.2 auf, und die zweite Gruppe CCT2 die Untergruppen Bin 2.1 und Bin 2.2.

Um dies zu vermeiden, ist in Fig. 5 nunmehr eine alternative Anordnung von LEDs auf einem LED-Modul, das von der beanspruchten Erfindung abgedeckt wird, dargestellt. Dabei werden die LEDs der gleichen nominalen Farbtemperatur nebeneinander positioniert, wobei jedoch jeweils LEDs verschiedener Unterkategorien nebeneinander angeordnet sind. Somit wechseln sich also die für jede nominale Farbtemperatur CCT1', CCT2' gewählten LEDs hinsichtlich der Farbtemperatur/nominalen Farbtemperatur und hinsichtlich der Chromatizitätskoordinaten x und y (Farbort) ab und sind insbesondere periodisch alternierend angeordnet, während für jede nominale Farbtemperatur LEDs unterschiedlicher Unterkategorien angeordnet sind. In Fig. 5 sind nun also insbesondere mehr als eine LED der ersten Gruppe (CCT1') abwechselnd mit mehr als einer LED der zweiten Gruppe (CCT2') angeordnet. Die beiden Gruppen weisen dabei Untergruppen auf, also insbesondere LEDs verschiedener Unterkategorien. So weist die erste Gruppe CCT1' die Untergruppen Bin 1.1' und Bin 1.2' auf, und die zweite Gruppe CCT2' die Untergruppen Bin 2.1' und Bin 2.2'.

Die Auswahl der LEDs erfolgt dabei nach den entsprechend definierten Unterkategorien und zwar erfindungsgemäß insbesondere so, dass sich die Unterkategorien der für eine nominale Farbtemperatur gewählten LEDs diagonal gegenüber liegen, sich die entsprechenden geometrischen Unterkategorie-Flächen in dem entsprechenden Kategorien-Diagramm also vorzugsweise lediglich höchstens in einem Punkt berühren. Die Flächen können dabei im Prinzip, abhängig von dem verwendeten Koordinatensystem, beliebige geometrische Formen annehmen, sind vorzugsweise jedoch konvexe geometrische Flächen, die insbesondere im Wesentlichen rechteckig/trapezförmig bzw. viereckig sind.

Die LEDs der Untergruppen sind vorzugsweise aus mindestens zwei diagonal gegenüber liegenden Unterkategorie-Flächen ausgewählt worden. Es ist auch denkbar, daß die LEDs der Untergruppen aus bspw. 4 solchen gegenüber liegenden Unterkategorie-Flächen paarweise ausgewählt werden. Die Temperaturbereiche für die Farbtemperaturen können z.B. wie folgt gegliedert sein: Warmem weissen Licht ist ein Farbtemperaturbereich von 2700 K bis 3700 K, neutralem weissen Licht ein Farbtemperaturbereich von 3700 K bis 5000 K und kaltem weissen Licht ist ein Farbtemperaturbereich von 5000 K bis 10000 K zugeordnet. Die Farbtemperatur der LEDs der ersten Gruppe CCT1, CCT1' können z.B. in einem Bereich zwischen 2000K und 4000K, somit also eher im warmen bis neutralen Farbtemperaturbereich, und die Farbtemperatur der LEDs der zweiten Gruppe CCT2, CCT2' in einem Bereich zwischen 5000K und 7500K, somit eher im kalten Farbtemperaturbereich, liegen.

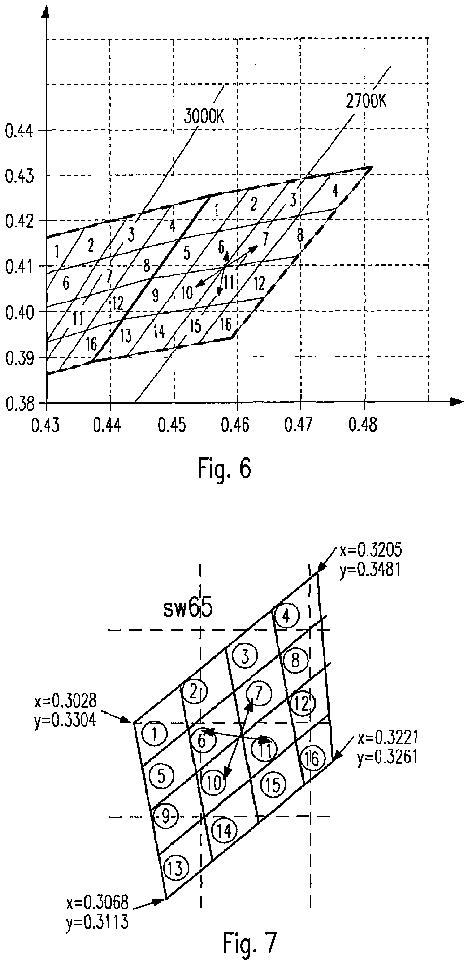

Fig. 6 zeigt exemplarisch Kategorien für eine nominale Farbtemperatur, hier die nominale Farbtemperatur von 2700 Kelvin, wobei die im Wesentlichen matrixförmig angeordneten Unterkategorien nun mit Nummern bezeichnet sind. Im gezeigten Beispiel sind die Unterkategorien in dieser matrixförmigen Anordnung im Wesentlichen zeilenweise nummeriert. Natürlich kann auch eine spaltenweise Nummerierung erfolgen.

Die präsentierten nummerierten Unterkategorien der gleichen nominalen Farbtemperatur sind durch ihren Farborten (Chromatizitätskoordinaten x und y) (und durch ihren Farbtemperatur (CCT)) unterscheidbar und die Gruppe (die Kategorie) folgt dem ANSI Standard C78.377-2008. Je nominale Farbtemperatur sind die Chromatizitätskoordinaten x und y des Zentrums des Kategorienbereichs mit ihrem Toleranzfenster (Tolerance Quadrangle) mit ihren Eckpunkten durch den ANSI Standard festgelegt. Die Unterkategorien sind nicht durch den ANSI Standard definiert. Es gibt mehrere Möglichkeiten die Unterkategorien innerhalb einer Kategorie (nominales CCT Quadrat) zu definieren. Abhängig vom LED-Hersteller gibt es unterschiedliche Unterkategorien, die zu einer nominalen Farbtemperatur angeordnet sind. Mit den Pfeilen sind die Unterkategorien (sgn. Crossbins) illustriert, aus denen bspw. die LEDs der Untergruppen CCT1' Bin1.1' und CCT1' Bin 1.2' der Figur 5 ausgewählt werden können.

Fig. 7 zeigt exemplarisch Unterkategorien für die nominale Farbtemperatur von 6500 Kelvin. Hier sind die einzelnen Unterkategorien ebenfalls nummeriert. Im gezeigten Beispiel sind die Unterkategorien wiederum in einer matrixförmigen Anordnung angeordnet und im Wesentlichen zeilenweise nummeriert. Natürlich kann auch hier eine spaltenweise Nummerierung erfolgen.

Für die entsprechende Farbtemperatur kann dann beispielsweise für die LEDs als erste Untergruppe die Unterkategorie 6 oder 7 gewählt werden, und als zweite Untergruppe die Unterkategorie 10 oder 11. Es ist dabei wichtig, dass immer die überkreuz liegenden Kategorien gewählt werden, wobei diese nicht notwendigerweise aneinander grenzen müssen. So werden vorzugsweise mit LEDs aus Unterkategorie 6 LEDs der Unterkategorie 11, bzw. mit LEDs aus Unterkategorie 7 LEDs der Unterkategorie 10 verwendet. Mit den Pfeilen sind die Unterkategorien (sgn. Crossbins) illustriert, aus denen bspw. die LEDs der Untergruppen CCT2' Bin2.1' und CCT2' Bin 2.2' der Figur 5 ausgewählt werden können. Entsprechend wäre eine Zuordnung der Unterkategorien 5+12, 9+8, 2+15, 1+16, usw. möglich.

Im Fall von wie in den Figuren 6 und 7 nummerierten Unterkategorien ist somit die Summe der Unterkategorienummern jeweils gleich, hier insbesondere 17 Die ANSI Gruppen/Kategorien sind bspw. in 4, 6, 9, 12 oder 16 Unterkategorien abhängig von dem Hersteller aufgeteilt.

Somit kann der kombinierte Farbort der LEDs einer Gruppe, also mit Untergruppen von LEDs einer Kategorie gemäß dieser Auswahl auch mit LEDs aus Kategorien erreicht werden, die weiter von der Schwarzkörperkurve entfernt liegen, also insbesondere eine höhere Tönung aufweisen.

Durch diese Anordnung kann sich insbesondere eine Farbortgenauigkeit gemäß Standard Deviation of Colour Matching 3 (SDCM 3) vom Mittelpunkt (d.h. bezüglich eines Zentralen Punkts der geometrischen Fläche) der betrachteten Kategorien aus ergeben. Somit kann eine Farbtemperaturkombination für jeden Farbwert umgesetzt werden. Der Mittelpunkt kann dabei durch seine Koordinaten im Farbraum für jede Kategorie definiert sein.

Die Erfindung bezieht sich also vorzugsweise auf ein Zweikanal LED-Modul. Dabei weist ein erster Kanal farbstoffkonvertierte Weisslicht-LEDs einer ersten nominalen Farbtemperatur, beispielsweise im Farbtemperaturbereich von 2700 Kelvin bis 3700 Kelvin, auf, und ein zweiter Kanal farbstoffkonvertierte Weisslicht-LEDs einer zweiten nominalen Farbtemperatur, beispielsweise im Farbtemperaturbereich von 5000 Kelvin bis 10 000 Kelvin. Insbesondere kann der erste LED-Kanal farbstoffkonvertierte Weisslicht-LEDs aufweisen, die eine nominale Farbtemperatur von 2700 Kelvin aufweisen, während der zweite LED-Kanal farbstoffkonvertierte Weisslicht-LEDs mit einer nominalen Farbtemperatur von 6500 Kelvin aufweisen kann.

Innerhalb jedes der verwendeten Kanäle, d.h. innerhalb jedes Kanals mit einer nominalen Farbtemperatur, sind LEDs unterschiedlicher Unterkategorien angeordnet, wobei die Unterkategorien, in die die LEDs eingeordnet sind, hinsichtlich des Farborts, bzw. der Farbkoordinaten der jeweiligen LEDs aufgelöst sind. In einer Ausführungsform sind dabei die LEDs in dem LED-Modul linear in einer Reihe auf einem Träger angeordnet. Es ist jedoch selbstverständlich möglich die LEDs in jeder beliebigen Formation z.B. in Matrixform anzuordnen.

In einer Ausführungsform wechseln sich somit die LEDs in ihrer Anordnung nicht mehr nur bezüglich der verwendeten Kanäle ab, d.h. beispielsweise wechselt sich ein LED-Kanal mit LEDs einer warmen nominalen Farbtemperatur nicht nur mit einem LED-Kanal mit LEDs einer kälteren nominalen Farbtemperatur ab, sondern die in einem Kanal verwendeten LEDs aus wenigstens zwei unterschiedlichen Unterkategorien je Kanal werden auch noch vorzugsweise periodisch permutiert.

Um nun ein Licht einer bestimmten Farbtemperatur erzeugen zu können, findet insbesondere ein Farbdimmen statt, bei dem die wenigstens zwei LED-Kanäle so angesteuert werden, dass das durch sie erzeugte Mischlicht die gewünschte Farbtemperatur annimmt. Dabei kann beispielsweise das Tastverhältnis der Ansteuerung und insbesondere das Tastverhältnis eines für jeden Kanal separat verwendeten LED-Stroms beliebig veränderbar sein, sodass zwischen den in den LED-Kanälen erzeugten Farbtemperaturen ein Farbdimmen möglich ist.

Eine bevorzugte Anwendung der erfindungsgemäßen LED-Module mit der linearen Anordnung der LEDs sind Retrofit-Lampen, die beispielsweise als Ersatz für Gasentladungslampen, z.B. Neonröhren, zum Einsatz kommen. Die erfindungsgemäßen LED-Module sind daher vorzugsweise so ausgestaltet, dass sie hinsichtlich der mechanischen und elektrischen Anschlüsse für Gasentladungslampen so ausgestaltet sind, dass sie als Ersatz für die Gasentladungslampen zum Einsatz kommen können. Insbesondere ist eine Anwendung der LED-Module in sogenannten Langfeld-LED-Leuchten vorgesehen.

Wenn die LEDs in einem LED-Modul mit wenigstens zwei LED-Kanälen aus mehr als zwei unterschiedlichen Unterkategorien je nominaler Farbtemperatur zum Einsatz kommen, sind die zur Auswahl möglichen Unterkategorien gemäß der Erfindung so zu wählen, dass sich die Verbindungslinien ihrer Mittelpunkte in dem entsprechenden Kategorien-Diagramm in einem gemeinsamen Punkt treffen. So ergibt sich stets der gleiche Summenfarbort. Dabei ist zu beachten, dass sich vorzugsweise die Farbtemperatur-Kategorie eines Kanals innerhalb einer McAdams 3 oder McAdams 4 Ellipse befindet.

## Patentansprüche

1. LED-Modul, aufweisend: wenigstens eine erste Gruppe seriell verschalteter farbstoffkonvertierter weisser LEDs und eine zweite Gruppe seriell verschalteter farbstoffkonvertierter weisser LEDs, wobei: die erste Gruppe und die zweite Gruppe an LEDs zueinander parallel geschaltet sind, so dass sie unabhängig voneinander von einer oder mehreren Treiberschaltungen ansteuerbar sind, sich die nominale Farbtemperatur der LEDs der ersten Gruppe von der nominalen Farbtemperatur der LEDs der zweiten Gruppe unterscheidet, **dadurch gekennzeichnet, dass** jede Gruppe an LEDs wenigstens zwei Untergruppen mit LEDs aufweist, wobei sich die Untergruppen hinsichtlich des Farborts unterscheiden, und dass:
die Gruppen sowie die Untergruppen an LEDs auf einem Träger in einer Erstreckungsrichtung in einem sich periodisch wiederholenden Muster angeordnet sind,
die LEDs linear in einer Reihe auf dem Träger angeordnet sind, mindestens zwei LEDs aus der gleichen Gruppe nebeneinander auf dem Träger angeordnet sind, und benachbarte LEDs der linearen Reihenfolge aus unterschiedlichen Untergruppen stammen.

2. LED-Modul nach Anspruch 1,
wobei die nominale Farbtemperatur der ersten Gruppe der farbstoffkonvertierten weissen LEDs in einem Bereich zwischen 2000K und 4000K liegt und die nominale Farbtemperatur der zweiten Gruppe der farbstoffkonvertierten weissen LEDs in einem Bereich zwischen 5000K und 7500K liegt.

3. LED-Modul nach einem der vorhergehenden Ansprüche, aufweisend eine oder mehrere Treiberschaltungen, die die LED-Gruppen mit einem PWM-modulierten Strom mit einstellbarem Tastverhältnis versorgen.

4. LED-Modul nach einem der vorhergehenden Ansprüche, wobei das LED-Modul ein Chip Scale Package oder ein Teil davon ist.

5. Lampe oder Leuchte mit einem LED-Modul nach einem der Ansprüche 1 bis 4, insbesondere eine Retrofit-LED-Lampe.

## Claims

1. LED module, comprising: at least one first group of serially connected dye-converted white LEDs and a second group of serially connected dye-converted white LEDs, wherein: the first group and the second group of LEDs are connected to one another in parallel, such that the groups can be controlled independently of one another by one or more driver circuits, and the nominal color temperature of the LEDs of the first group is different than the nominal color temperature of the LEDs of the second group, **characterized in that**
each group of LEDs comprises at least two sub-groups of LEDs, wherein the sub-groups differ with respect to the color location, and that:
the groups and the sub-groups of LEDs are disposed on a carrier in an extension direction in a periodically repeating pattern,
the LEDs are disposed linearly in a row on the carrier,
at least two LEDs from the same group are disposed next to one another on the carrier, and
adjacent LEDs in the linear sequence are from different sub-groups.

2. LED module according to Claim 1,
wherein the nominal color temperature of the first group of dye converted white LEDs is in a range between 2000K and 4000K and the nominal color temperature of the second group of dye converted white LEDs is in a range between 5000K and 7500K.

3. LED module according to any one of the preceding claims,
comprising one or more driver circuits which supply the LED groups with a PWM modulated current with an adjustable duty cycle.

4. The LED module according to any one of the preceding claims, wherein the LED module is a chip scale package or a part thereof.

5. Light or lamp comprising an LED module according to any one of Claims 1 to 4, in particular a retrofit LED lamp.

## Revendications

1. Module LED, présentant : au moins un premier groupe de LED blanches converties par colorant montées en série et un deuxième groupe de LED blanches converties par colorant montées en série :
le premier groupe et le deuxième groupe de LED étant montées en parallèle les unes aux autres, de telle façon qu'elles puissent être commandées indépendamment les unes des autres par un ou plusieurs circuits pilotes, la temperature de couleur nominale des LED du premier groupe étant différente de la température de couleur nominale des LED du deuxième groupe, **caractérisé en ce que**
chaque groupe de LED présente au moins deux sous-groupes de LED, les sous-groupes étant différents quant à la chromaticité et **en ce que** :
les groupes ainsi que les sous-groupes de LED sont disposés sur un support dans une direction d'extension selon un motif répété périodiquement,
les LED sont disposées linéairement en une rangée sur le support,
au moins deux LED du même groupe sont disposées l'une à côté de l'autre sur le support, et
des LED voisines de la séquence linéaire proviennent de sous-groupes différents.

2. Module LED selon la revendication 1,
dans lequel la temperature de couleur nominale du premier groupe de LED blanches converties par colorant se trouve dans une plage entre 2000K et 4000K et la temperature de couleur nominale du deuxième groupe de LED blanches converties par colorant se trouve dans une plage entre 5000K et 7500K.

3. Module LED selon l'une quelconque des revendications précédentes,
présentant un ou plusieurs circuits pilotes, qui alimentent les groupes de LED avec un courant modulé par durée d'impulsion avec un rapport cyclique réglable.

4. Module LED selon l'une quelconque des revendications précédentes, dans lequel le module LED est un boîtier à échelle de puce ou une partie d'un tel.

5. Lampe ou luminaire comprenant un module LED selon l'une quelconque des revendications 1 à 4, en particulier une lampe retrofit LED.
